(19) **Europäisches Patentamt** / **European Patent Office** / **Office européen des brevets**

(11) **EP 4 726 959 A1**

(12) **EUROPEAN PATENT APPLICATION**
published in accordance with Art. 153(4) EPC

(43) Date of publication:
**15.04.2026 Bulletin 2026/16**

(21) Application number: **25809989.4**

(22) Date of filing: **13.02.2025**

(51) International Patent Classification (IPC):
*H02J 7/00* (2026.01)    *G01R 19/165* (2006.01)
*G01R 31/382* (2019.01)

(52) Cooperative Patent Classification (CPC):
**G01R 19/165; G01R 31/382; H02J 7/00**

(86) International application number:
**PCT/KR2025/002090**

(87) International publication number:
**WO 2025/234568 (13.11.2025 Gazette 2025/46)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **09.05.2024 KR 20240061166**

(71) Applicant: **LG Energy Solution, Ltd.**
**Seoul 07335 (KR)**

(72) Inventors:
• **LEE, Chung Yong**
  **Daejeon 34122 (KR)**
• **KIM, Yonghwan**
  **Daejeon 34122 (KR)**

(74) Representative: **BCKIP Part mbB**
**MK1**
**Landsbergerstraße 98, 3.Stock**
**80339 München (DE)**

(54) **BATTERY CONTROL DEVICE AND METHOD**

(57)    A battery control device, according to one embodiment of the present invention, is located in a battery system including a plurality of batteries, and may comprise: at least one processor; and a memory that stores at least one command executed by the at least one processor. The at least one command may include: a command for monitoring the voltage of each of the batteries while the batteries are connected in parallel to a DC link and charged; a command for sequentially disconnecting batteries that have reached a predetermined target voltage from the DC link; and a command for reconnecting a battery, among the batteries disconnected from the DC link, of which the voltage difference with the last battery connected to the DC link is within a set range when the last battery connected to the DC link reaches the target voltage, to the DC link.

[Figure 5]

**Description**

[Technical Field]

This application claims priority to and the benefit of Korean Patent Application No.10-2024-0061166 filed in the Korean Intellectual Property Office on May 9, 2024 the entire contents of which are incorporated herein by reference.

The present invention relates to a battery control apparatus and controlling method thereof, and more particularly, to a battery control apparatus and controlling method thereof applicable to a battery system including a battery with a voltage plateau section.

[Background Art]

Secondary batteries, capable of recharging and reuse, may be used as an energy source for small devices such as mobile phones, tablet PCs and vacuum cleaners, and also used as an energy source for medium and large devices such as automobiles and an energy storage system (ESS) for smart grids.

Secondary batteries may be applied to a system in a form of an assembly such as a battery module in which a plurality of battery cells is connected in series and parallel or a battery rack in which battery modules are connected in series and parallel according to system requirements. For medium and large-sized devices such as an energy storage system (ESS) for smart grids, a high-capacity battery system with multiple battery racks connected in parallel may be applied to satisfy required capacity of the device.

Carbon materials are mainly used as an anode active material of lithium secondary batteries, and lithium-containing cobalt oxide ($LiCoO_2$) is mainly used as a cathode active material. In addition, lithium-containing manganese oxides ($LiMnO_2$, $LiMn_2O_4$, etc.) and lithium-containing nickel oxide ($LiNiO_2$) are also being considered. Recently, a lithium iron phosphate ($LiFePO_4$)-based compound has been used as a cathode active material for a lithium secondary battery. A lithium iron phosphate (LFP) battery using lithium iron phosphate as a cathode active material is superior in terms of thermal stability and cost efficiency compared to other types of batteries.

However, the LFP battery shows a flat characteristic with a voltage plateau in a charge characteristic curve (a relationship curve between open circuit voltage and SOC), and a problem arises due to this that SOC (State Of Charge) cannot be accurately estimated in the plateau section. Accordingly, a battery system with LFP batteries performs a SOC compensation process when a battery voltage is in the high voltage range or low voltage range.

However, when battery racks are reconnected in parallel to the DC link after this SOC compensation process is completed, an inrush current may occur in the battery system due to the characteristics of LFP batteries that experience a rapid voltage drop.

Among the prior art documents relevant to the present invention, KR 10-2361334 is of some relevance.

[Detailed Description of the Invention]

[Technical Problem]

To obviate one or more problems of the related art, embodiments of the present disclosure provide a battery control apparatus for preventing occurrence of inrush current in a battery system.

To obviate one or more problems of the related art, embodiments of the present disclosure also provide a battery control method performed by the battery control apparatus.

[Technical Solution]

In order to achieve the objective of the present disclosure, a battery control apparatus may include at least one processor; and a memory configured to store at least one instruction executed by the at least one processor.

Here, the at least one instruction may include an instruction to monitor a voltage of each of the batteries while the batteries are connected in parallel to a direct current (DC) link and being charged; an instruction to sequentially disconnect at least one battery that has reached a predefined target voltage from the DC link; and an instruction to, upon the last battery connected to the DC link reaching the target voltage, reconnect one or more batteries, among the at least one battery disconnected from the DC link, of which voltage difference from the last battery is within a set range, to the DC link.

The instruction to sequentially disconnect the at least one battery that have reached the predefined target voltage from the DC link may include an instruction to transmit a switch control signal for causing a switch connecting a battery and the DC link to be switched to an open state to a battery management apparatus of the at least one battery that has reached the predefined target voltage.

The instruction to sequentially disconnect the at least one battery that have reached the predefined target voltage from the DC link may include an instruction to correct State Of Charge (SOC) of the at least one battery that has reached the predefined target voltage and disconnect the at least one battery from the DC link.

The instruction to sequentially disconnect the at least one battery that have reached the predefined target voltage from the DC link may include an instruction to, upon the last battery connected to the DC link reaching the target voltage, correct the SOC of the last battery during the last battery is being connected to the DC link.

The instruction to reconnect one or more batteries to the DC link may include an instruction to reconnect at least one battery, among the at least one battery disconnected from the DC link, of which the voltage difference from the last battery is within the set range and SOC correction is completed, to the DC link.

The instruction to reconnect one or more batteries to the DC link may include an instruction to, during a process of discharging at least one battery connected to the DC link, sequentially reconnect one or more batteries whose voltage difference from the at least one battery connected to the DC link falls within a set range, among at least one battery which is not reconnected to the DC link, to the DC link.

The instruction to sequentially disconnect at least one battery that has reached the predefined target voltage from the DC link may include an instruction to calculate an SOC of the battery system based on SOC of at least one battery connected to the DC link; and an instruction to adjust charge current of the at least one battery connected to the DC link to be attenuated by a predefined amount if the SOC of the battery system is equal to or greater than a determined SOC.

According to another embodiment of the present disclosure, a battery control method, performed by battery control apparatus located in a battery system including a plurality of batteries, may include monitoring a voltage of each of the batteries while the batteries are connected in parallel to a direct current (DC) link and being charged; sequentially disconnecting at least one battery that has reached a predefined target voltage from the DC link; and upon the last battery connected to the DC link reaching the target voltage, reconnecting one or more batteries, among the at least one battery disconnected from the DC link, of which voltage difference from the last battery is within a set range, to the DC link.

The sequentially disconnecting at least one battery that has reached a predefined target voltage from the DC link may include transmitting a switch control signal for causing a switch connecting a battery and the DC link to be switched to an open state to a battery management apparatus of the at least one battery that has reached the predefined target voltage.

The sequentially disconnecting at least one battery that has reached a predefined target voltage from the DC link may include correcting a state of charge (SOC) of the at least one battery that has reached the predefined target voltage and disconnect the at least one battery from the DC link.

The sequentially disconnecting at least one battery that has reached a predefined target voltage from the DC link may include, upon the last battery connected to the DC link reaching the target voltage, correcting the SOC of the last battery during the last battery is being connected to the DC link.

The reconnecting one or more batteries to the DC link may include reconnecting at least one battery, among the at least one battery disconnected from the DC link, of which the voltage difference from the last battery is within the set range and SOC correction is completed, to the DC link.

The reconnecting one or more batteries to the DC link may include during a process of discharging at least one battery connected to the DC link, sequentially reconnecting one or more batteries whose voltage difference from the at least one battery connected to the DC link falls within a set range, among at least one battery which is not reconnected to the DC link, to the DC link.

The sequentially disconnecting at least one battery that has reached a predefined target voltage from the DC link may include calculating an SOC of the battery system based on SOC of at least one battery connected to the DC link; and adjusting charge current of the at least one battery connected to the DC link to be attenuated by a predefined amount if the SOC of the battery system is equal to or greater than a determined SOC.

[Advantageous Effects]

According to the embodiments of the present invention as described above, it is possible to prevent inrush current from occurring in a battery system.

[Brief Description of the Drawings]

FIG. 1 is a block diagram of a general energy storage system.
FIG. 2 shows a charge characteristic curve of an LFP battery.
FIG. 3 is a graph for explaining a general battery control method.
FIG. 4 is a block diagram of a battery system according to embodiments of the present invention.
FIG. 5 is an operational flowchart of a battery control method according to an embodiment of the present invention.

FIGS. 6 and 7 are reference diagrams for explaining a battery control method in a charge mode according to embodiments of the present invention.

FIG. 8 is an operational flowchart of a battery control method according to another embodiment of the present invention.

FIG. 9 is an operational flowchart of a battery control method according to another embodiment of the present invention.

FIG. 10 is a reference diagram for explaining a battery control method according to another embodiment of the present invention.

FIG. 11 is a block diagram of a battery control apparatus according to embodiments of the present invention.

100 : battery
200 : battery management apparatus
300, 1100 : battery control apparatus

[Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a basic unit that serves to store power and a battery module refers to an assembly in which a plurality of battery cells is electrically connected.

A battery rack refers to a system of a single structure which is assembled by connecting module units set by a battery manufacturer in series/parallel and may be monitored and controlled by a battery management apparatus/system (BMS). A battery rack may include several battery modules and a battery protection unit or any other protection device.

A battery bank refers to a group of large-scale battery rack systems configured by connecting a plurality of battery racks in parallel. A bank BMS for a battery bank may monitor and control several rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

State of Charge (SOC) refers to a current state of charge of a battery, represented in percent points [%], and State of Health (SOH) may be a current condition of a battery compared to its ideal or original conditions, represented in percent points [%].

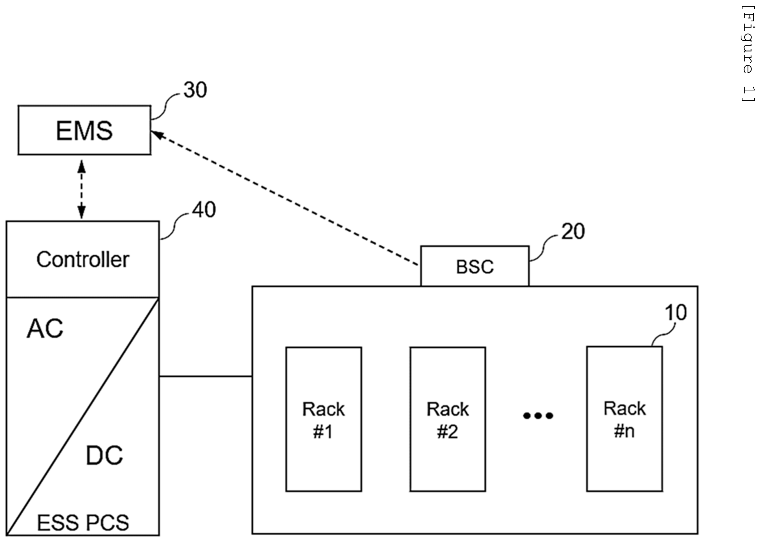

FIG. 1 is a block diagram of a general energy storage system.

In an energy storage system (ESS), a basic unit of battery for storing energy or power is a battery cell. Typycally, a seris/parallel combination of battery cells may form a battery module and multiple battery module may form a battery rack. In other words, a battery rack as a series/parallel combination of battery modules may be a basic unit of a battery system. Here, a battery module may be referred to as a battery pack depending on a device or a system in which the battery is used.

Referring to FIG. 1, a battery rack 10 may include multiple battery modules and a battery protection unit or any other protection device. A battery rack may be monitored and controlled through a rack battery management system (rack BMS). The RBMS may monitor a current, a voltage and a temperature of each battery rack to be managed, calculate a state of charge (SOC) of the battery based on a monitoring result, and control charging and discharging.

Meanwhile, the battery protection unit (BPU) is a device for protecting the battery from abnormal current and fault current in a battery rack. The BPU may include a main contactor (MC), a fuse, a circuit breaker (CB), or a disconnect switch (DS). Here, the main contactor may include a positive main contactor and a negative main contactor. The BPU may control the battery system rack by rack by controlling the main contactor on/off according to control of the RBMS. The BPU may also protect the battery from short-circuit current by using a fuse when a short-circuit occurs. As such, the existing battery system may be controlled through a protection device such as a BPU or a switch gear.

In addition, a battery system controller (BSC) 20 may be located in each battery section which includes a plurality of batteries, peripheral circuits, and devices, so as to monitor and control objects such as a voltage, a current, a temperature, and a circuit breaker. The battery system controller may be a top-level controller of a bank-level battery system including a plurality of battery racks and is also used as a controller in a battery system with a multiple bank-level structure.

Furthermore, a power conversion system (PCS) 40 installed in each battery section may perform actual charging/discharging based on a charge/discharge command from an energy management system (EMS) 30. The power conversion system may include a DC/AC inverter and a controller. Meanwhile, the output of each BPU may be connected to a power generation device (e.g., phtovoltaic system) and the PCS 40 which is connected to a power grid, through a DC link (or DC bus). In addition, the energy management system (EMS) 30 or the power management system (PMS) may control the energy storage system in overall.

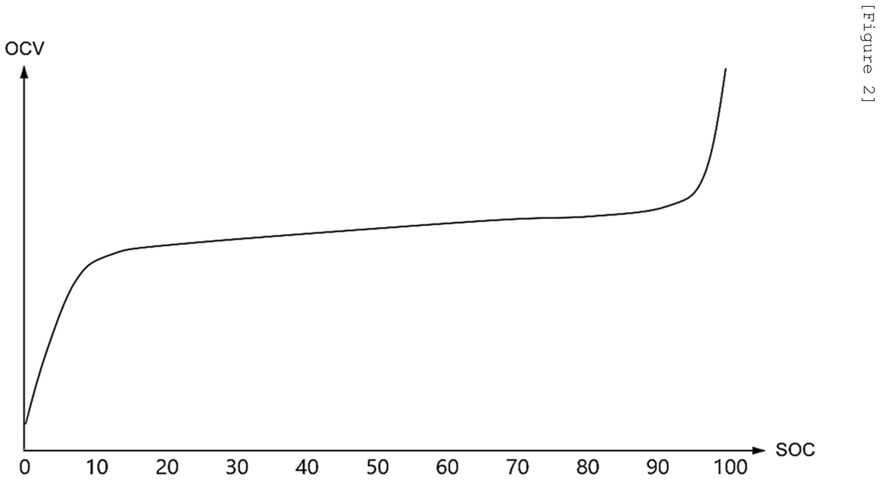

FIG. 2 shows a charge characteristic curve of an LFP battery.

More specifically, FIG. 2 shows a charge characteristic curve of a lithium iron phosphate (LFP) battery in which lithium iron phosphate is used as a cathode active material. The charge characteristic curve represents a correspondence between an open circuit voltage (OCV) and a SOC measured during a battery charging process.

In general, a battery control apparatus control batteries by using a charge characteristic curve of the battery. For example, the battery control apparatus may measure open circuit voltage values of the batteries, estimate SOCs of the batteries based on the charge characteristic curve of the battery, and perform balancing between the batteries or control parallel connection between the batteries based on the estimated SOCs.

Referring to FIG. 2, the charge characteristic curve of the LFP battery has a voltage plateau in a SOC range of about 10% to about 90%. In the case of the LFP battery having such a plateau characteristic, it is difficult to accurately estimate the SOC in the plateau section, so accurate estimation is possible only in non-plateau sections (e.g., sections where SOC is greater than 90%, or sections where SOC is less than 10%).

Accordingly, a battery system in which battery racks each including LFP battery cells are connected in parallel performs a SOC compensation process when the voltage of the battery racks is in a high voltage range or a low voltage range.

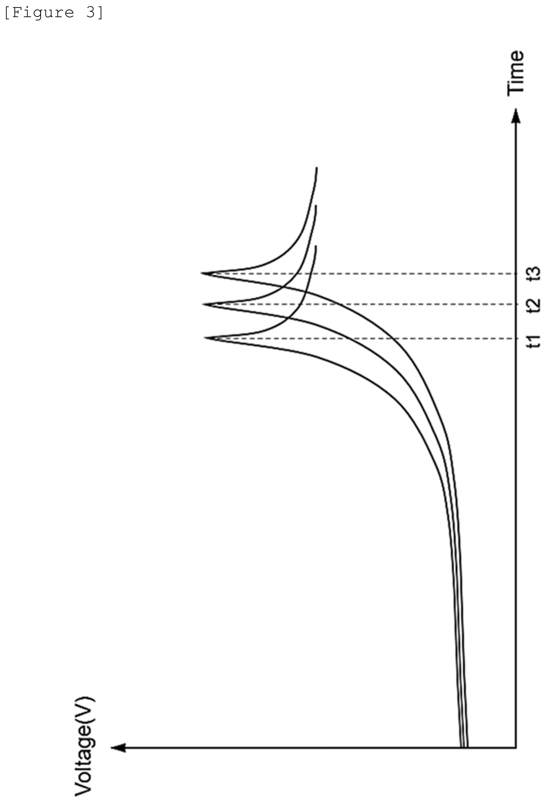

FIG. 3 is a graph for explaining a general battery control method.

In a battery system where one or more LFP batteries are applied, a battery control apparatus may perform a SOC correction process for a battery rack that has reached a high voltage section.

If a plurality of battery racks is included in the battery system, the racks that have reached a high voltage section are sequentially removed from the direct current (DC link), and the battery control apparatus may correct the SOC of each rack if all the racks are removed from the DC link. When the SOC correction of all the racks is completed, all the racks are simultaneously connected to the DC link and connected in parallel with each other.

However, when the battery racks are connected in parallel to the DC link again after this SOC correction process is completed, an inrush current may occur in the battery system due to the characteristics of the LFP battery, in which the voltage rapidly increases or decreases in an non-plateau section (for example, a section where the SOC is 90% or higher, or a section where the SOC is 10% or lower).

For example, as shown in FIG. 3, if Rack #1 reaches a target voltage at time t1 and is removed from the DC link, then Rack #2 reaches the target voltage at time t2 and is removed from the DC link, and then Rack #3 reaches the target voltage at time t3 and is removed from the DC link, a high voltage difference occurs between Rack #1, which is removed from the DC link first, and Rack #3, which is removed from the DC link last. After the SOC correction process is completed, when Racks #1 to #3 are connected to the DC link at the same time, a high inrush current may flow momentarily toward Rack #1 due to this high voltage difference.

The present invention has been made to solve this problem, and relates to a battery control apparatus and method for preventing inrush current from occurring in a battery system.

Hereinafter, exemplary embodiments of the present invention will be described in detail with reference to the accompanying drawings.

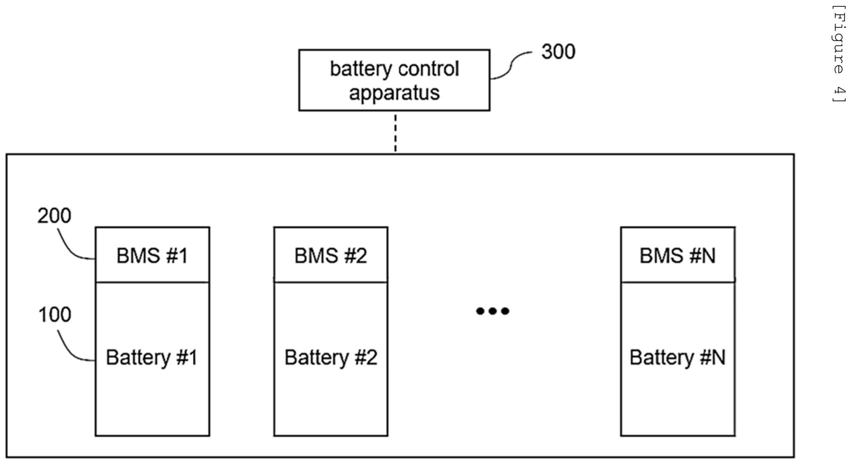

FIG. 4 is a block diagram of a battery system according to embodiments of the present invention.

Referring to FIG. 4, a battery system according to embodiments of the present invention may include a plurality of batteries 100, a plurality of battery management apparatuses 200 that are provided corresponding to each of the plurality of batteries and manage and control the corresponding batteries, and a battery control apparatus 300 that is connected to and interoperate with the plurality of battery management apparatuses 200.

The battery 100 may be a battery assembly including a plurality of unit cells that are electrically connected to each other. For example, the battery 100 may mean a battery rack, but the scope of the present invention is not limited thereto. In other words, the battery 100 according to the present invention may correspond to a battery module, a battery pack, or a battery bank.

The batteries 100 may be configured to be connected in parallel with each other. Here, each of the batteries 100 may be electrically connected to a direct current (DC) link and connected in parallel with other batteries.

Each of the batteries 100 may include a switch arranged at an input/output terminal, and when the switch is switched from a closed state to an open state, the electrical connection with the DC link is cut off and the parallel connection with another battery may be released. In contrast, when the switch of the battery 100 is switched from an open state to a closed state, the battery 100 may be electrically connected to the DC link and may be connected in parallel with other batteries.

The battery management apparatus 200 may collect state information on a corresponding battery 100 and perform a predetermined control operation based on the collected state information, thereby managing and controlling the corresponding battery 100. Here, the state information may include at least one of the voltage value and SOC value of the battery, and the voltage value and SOC value of each of the unit cells included in the battery.

The battery management apparatus 200 may control the operation of the switch provided at the input/output terminal of the battery 100.

Each of the battery management apparatus 200 may be connected to the battery control apparatus 300 through a network, transmit battery state information to the battery control apparatus 300, and receive a control command from the battery control apparatus 300 to operate. Here, the battery management apparatus 200 may receive a switch control signal for controlling the operation of the switch from the battery control apparatus 300 and control on/off operation of the switch according to the switch control signal.

The battery control apparatus 300 may monitor and control the operation status of each of the battery management apparatuses 200.

The battery control apparatus 300 may correspond to a Battery System Controller (BSC), an Energy Management System (EMS), or a Power Management System (PMS).

The battery control apparatus 300 may monitor voltage of each battery during a process of charging the batteries in a state in which the batteries are connected in parallel to the DC link (online state), and sequentially disconnect batteries that have reached a predetermined target voltage from the DC link.

In the process of sequentially switching online batteries to offline state, when only one battery connected to the DC link remains, the battery control apparatus 300 may select a target battery whose voltage difference with the online battery is within a set range, among offline batteries, while the last online battery is being connected to the DC link.

Thereafter, the battery control apparatus 300 may reconnect the selected target battery to the DC link and switch it to online state.

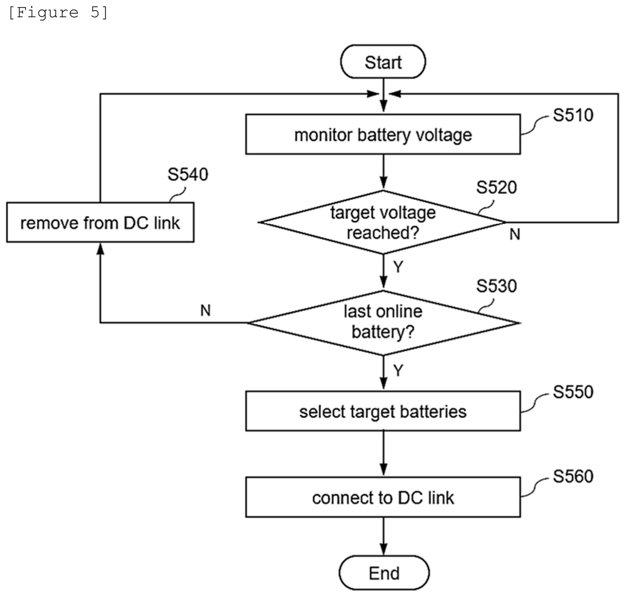

FIG. 5 is an operational flowchart of a battery control method in a charge mode according to an embodiment of the present invention.

The battery control method according to embodiments of the present invention may be performed by a battery control apparatus located in a battery system including a plurality of batteries. Here, the battery control apparatus may correspond to an upper control apparatus that is connected and interoperates with the battery management apparatuses of each of the batteries, and may correspond to, for example, a Battery System Controller (BSC), an Energy Management System (EMS), or a Power Management System (PMS) that is connected and interoperates with a plurality of BMSs.

The battery control apparatus may monitor voltage of each of online batteries during a process in which the batteries are being charged in a state in which they are connected in parallel to the DC link (online state) (S510).

Here, the battery control apparatus may receive the voltage of the battery or the voltage of each unit cell from the battery management apparatus of each battery.

The battery control apparatus may detect one or more batteries among the online batteries that have reached a predetermined target voltage (S520). Here, the target voltage may be predefined as a minimum voltage value from which an SOC can be estimated.

The battery control apparatus may determine a corresponding battery as a battery that has reached the target voltage when the maximum voltage value among voltage values of the unit cells included in the corresponding battery reaches the target voltage.

The battery control apparatus may sequentially remove batteries that have reached the target voltage from the DC link until only one battery remains online.

Specifically, when the voltage of a specific online battery reaches the target voltage (Y of S520), the battery control apparatus may check whether the battery is the last battery connected to the DC link (S530).

If the battery that has reached the target voltage is not the last online battery (N of S530), the battery control apparatus may remove the battery from the DC link and switch it to an offline state (S540). Here, the battery control apparatus may transmit a switch control signal that causes a switch connecting the battery and the DC link to be switched to an open state to the battery management apparatus of the online battery that has reached the target voltage, thereby removing the battery from the DC link.

If the battery that has reached the target voltage is the last online battery (Y of S530), the battery control apparatus may select one or more target batteries of which the voltage difference with the last online battery is within a set range, among the offline batteries that have been disconnected from the DC link, while the last online battery is being connected to the DC link (S550).

Thereafter, the battery control apparatus 300 may reconnect the one or more selected target batteries to the DC link and switch the batteries to online state (S560).

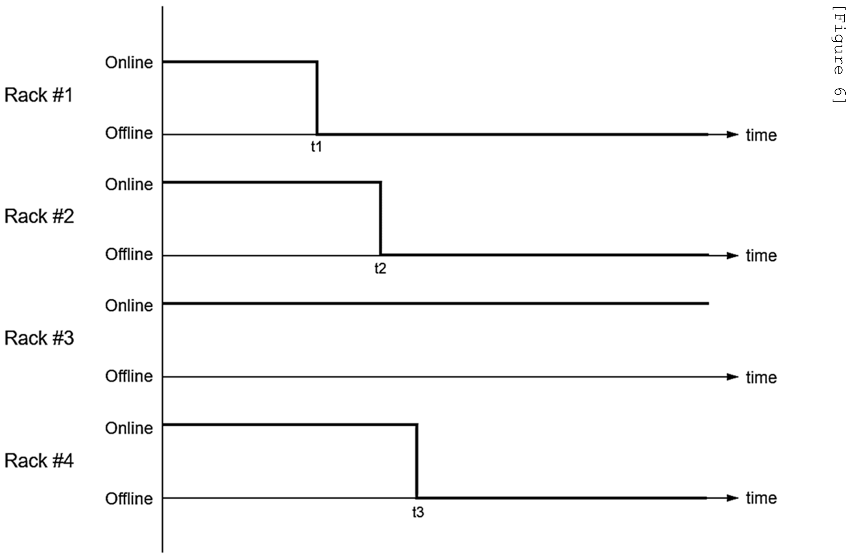

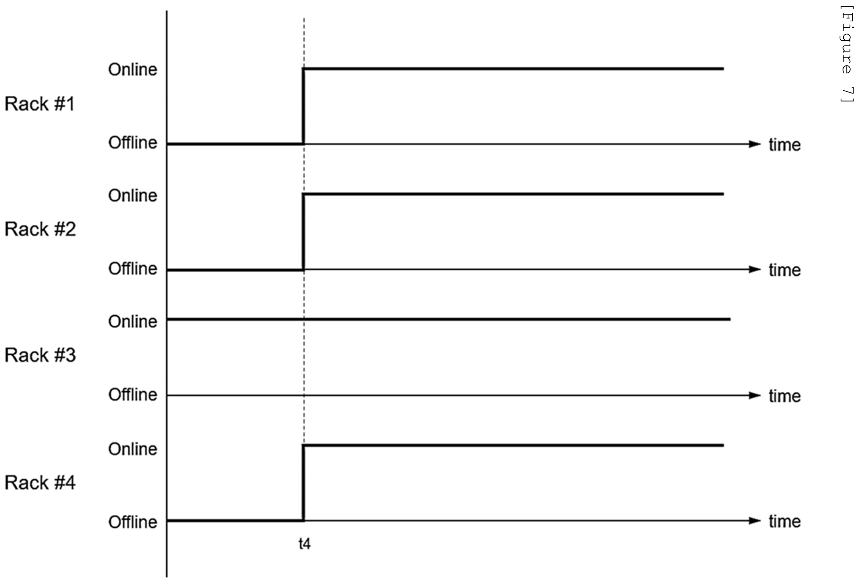

FIGS. 6 and 7 are reference diagrams for explaining a battery control method in a charge mode according to embodiments of the present invention. Hereinafter, with reference to FIGS. 6 and 7, a battery control method according to embodiments of the present invention will be explained using a battery system including four battery racks connected in parallel as an example.

The battery control apparatus may monitor voltage of each of the racks (Rack #1 to #4) during a charge process of the racks in online state.

If the voltage of Rack #1 reaches a target voltage (e.g., 3.6 V) at time t1, as shown in FIG. 6, the battery control apparatus may disconnect Rack #1 from the DC link at time t1 and switch it to an offline state.

Thereafter, if the voltage of Rack #2 reaches the target voltage at time t2, the battery control apparatus may disconnect Rack #2 from the DC link at time t2 and switch it to an offline state.

Afterwards, if the voltage of Rack #4 reaches the target voltage at time t3, the battery control apparatus may switch Rack #4 to an offline state by disconnecting Rack #4 from the DC link at time t3.

Thereafter, if the voltage of Rack #3 reaches the target voltage, the battery control apparatus may select at least one target rack while Rack #3 is connected to the DC link without switching Rack #3 to an offline state.

For example, as shown in FIG. 7, if the voltage of Rack #3 reaches the target voltage at time t4, the battery control apparatus may calculate voltage difference between Rack #3 and the offline racks (Rack #1, 2, 4). Afterwards, the battery control apparatus may select a rack whose voltage difference with Rack #3 is within a preset voltage range (for example, 0.2 V), among the offline racks, and switch the selected rack to an online state. If all offline racks (Rack #1, 2, 4) are selected as target racks, all offline racks (Rack #1, 2, 4) may be reconnected to the DC link and brought online, as shown in Fig. 7.

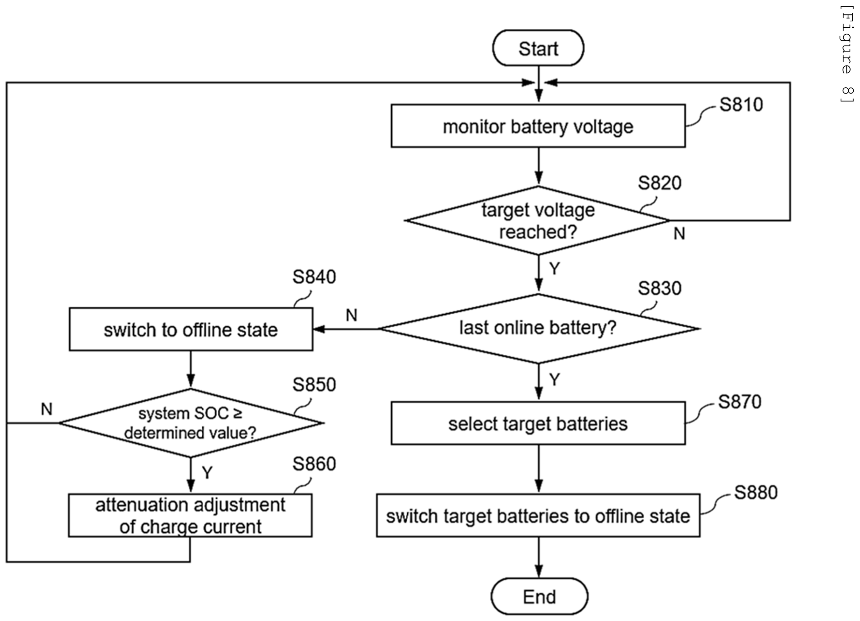

FIG. 8 is an operational flowchart of a battery control method according to another embodiment of the present invention.

The battery control apparatus may monitor voltage of each of online batteries during a process of charging online batteries (S810).

The battery control apparatus may detect one or more batteries among the online batteries that have reached a predetermined target voltage (S820). Here, the target voltage may be predefined as a minimum voltage value from which an SOC can be estimated.

If the voltage of a specific online battery reaches the target voltage (Y of S520), the battery control apparatus may check whether the battery is the last online battery (S830).

If the battery that has reached the target voltage is not the last online battery (N of S830), the battery control apparatus may disconnect the battery from the DC link and switch it to an offline state (S840).

Thereafter, the battery control apparatus may determine whether the SOC of the battery system is greater than or equal to a set value (S850).

Specifically, the battery control apparatus may calculate the SOC of the battery system based on SOCs of each online battery currently connected to the DC link.

In an embodiment, the SOC of the battery system may be calculated as an average value of SOCs of respective online batteries.

In another embodiment, the SOC of the battery system may be calculated according to the following equation.

[Equation 1]

$$SOC_{system} = \frac{SOC_{min}}{100 - (SOC_{max} - SOC_{min})} * 100$$

(Here, SOCmax is the maximum value among the battery SOC values, and SOCmin is the minimum value among the battery SOC values)

For example, if the SOCs of five racks are respectively 100%, 99%, 99.5%, 98%, and 99.5%, the SOC of the battery system may be calculated as 99.2% according to equation 1.

Thereafter, the battery control apparatus may determine whether the calculated SOC of the battery system is greater than or equal to a set value (e.g., 98%).

If the SOC of the battery system is greater than or equal to the set value (Y of S850), the battery control apparatus may adjust charge current flowing in the DC link to be attenuated by a predetermined size (S860).

In an embodiment, the battery control apparatus may transmit a control signal for adjusting attenuation of the charge current to a power control device connected to the DC link and controlling the charge and discharge power of the battery. For example, the battery control apparatus may transmit a command for adjusting the charge power limit value to be attenuated to a power conversion system (PCS) of the battery system. Here, the PCS may reset the predetermined charge power limit value to a value lower by a predefined size (e.g., 0.05 CP) so that the charge current flowing in the DC link is attenuated.

In another embodiment, the battery control apparatus may transmit the attenuation adjusted charge current value or charge power value to a power control device connected to the DC link and controlling the charge and discharge power of the battery. For example, the battery control apparatus may transmit the attenuation-adjusted charge power limit value (e.g., 0.05 CP) to the power conversion system (PCS) of the battery system. Here, the PCS may reset the predetermined charge power limit value to a value received from the battery control apparatus, thereby attenuating the charge current flowing in the DC link.

If the SOC of the battery system is less than the set value (N of S850), the battery control apparatus may monitor the voltage of the online battery without attenuation adjustment of the charge current (S810).

If the battery that has reached the target voltage is the last online battery (Y of S830), the battery control apparatus may select one or more target batteries whose voltage difference from the last online battery is within a set range, among the offline batteries that have been disconnected from the DC link, while the last online battery is being connected to the DC link (S870).

Thereafter, the battery control apparatus 300 may reconnect the one or more selected target batteries to the DC link to switch them to online states (S880).

In other words, the battery control apparatus may monitor the SOC of the online battery during the process in which the online batteries that have reached the target voltage are sequentially switched to an offline state. Here, when the online battery approaches a full charge state, the battery control apparatus may control the charge current to be attenuated, thereby minimizing increase in the internal resistance (IR) of the online battery and minimizing voltage drop of the online battery due to charging. Accordingly, when all the batteries are fully charged and connected in parallel, the voltage deviation between the batteries can be minimized.

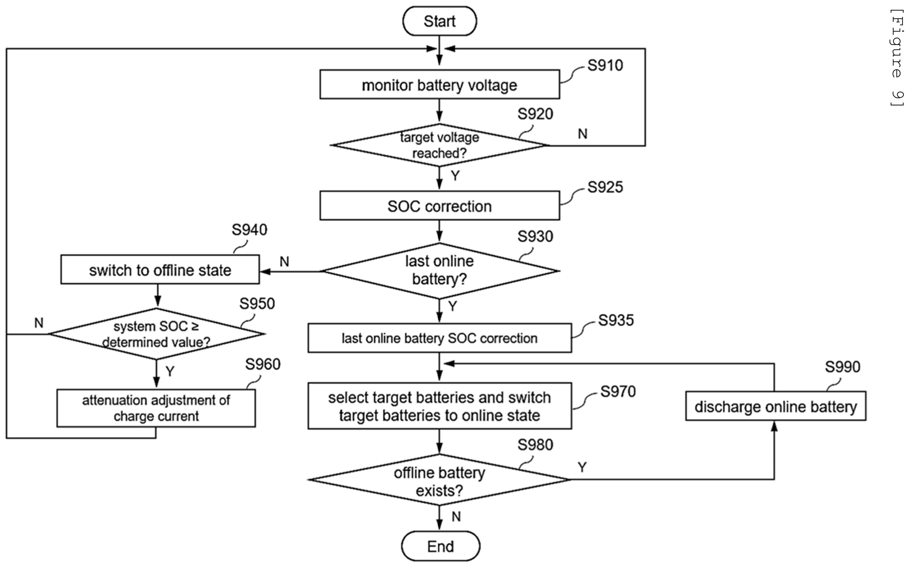

FIG. 9 is an operational flowchart of a battery control method according to another embodiment of the present invention.

The battery control apparatus may monitor voltage of each of online batteries during a charge process of online batteries (S910).

The battery control apparatus may detect one or more batteries, among the online batteries, that have reached a predetermined target voltage (S920). Here, the target voltage may be predefined as a minimum voltage value from which an SOC can be estimated.

If the voltage of a specific online battery reaches the target voltage (Y of S920), the battery control apparatus may correct the SOC of the battery (S925).

Thereafter, the battery control apparatus may check whether the battery is the last online battery (S930).

If the battery that has reached the target voltage is not the last online battery (N of S930), the battery control apparatus may disconnect the battery from the DC link and switch it to an offline state (S940).

Thereafter, the battery control apparatus may determine whether the SOC of the battery system is greater than or equal to a determined value (S950). Here, the battery control apparatus may calculate the SOC of the battery system based on the SOC of each online battery currently connected to the DC link. For example, the battery control apparatus may calculate the SOC of the battery system according to equation 1 described above.

If the SOC of the battery system is greater than or equal to the determined value (Y of S950), the battery control apparatus may adjust charge current flowing in the DC link to be attenuated by a predetermined amount (S960).

If the SOC of the battery system is less than the determined value (N of S950), the battery control apparatus may monitor the voltage of the online battery without attenuation adjustment of the charge current (S910).

If the battery that has reached the target voltage is the last online battery (Y of S930), the battery control apparatus may compensate the SOC of the last online battery while the last online battery is still connected to the DC link (S935).

The battery control apparatus may select one or more target batteries, among the offline batteries that are disconnected from the DC link, whose voltage difference from the last online battery is within a set range, and switch the selected target batteries to an online state (S970). In other words, the target battery may be a battery whose voltage difference from the last online battery is within a set range, among the offline batteries that are charged to the target voltage and have completed SOC correction.

Thereafter, the battery control apparatus may check whether there is an offline battery that is not connected to the DC link (S980). In other words, the battery control apparatus may check whether there is an offline battery that is charged to the target voltage and has completed SOC correction, but whose voltage difference from the last online battery exceeds the set range.

If there exists an offline battery (Y of S980), the battery control apparatus may select one ore more additional target batteries and sequentially switch the selected target batteries to an online state (S970), during a process of discharging at least one battery that is currently in an online state (S990).

In other words, when all batteries are fully charged and SOC compensation is completed, but there is a voltage difference between the batteries, the battery control apparatus may, with priority, switch the batteries within a set voltage range to an online state based on the voltage of the battery that was fully charged most recently. Thereafter, when the voltage of the online battery reaches the voltage of a specific offline battery during a discharge process of the online battery, the battery control apparatus may switch the specific offline battery to online state.

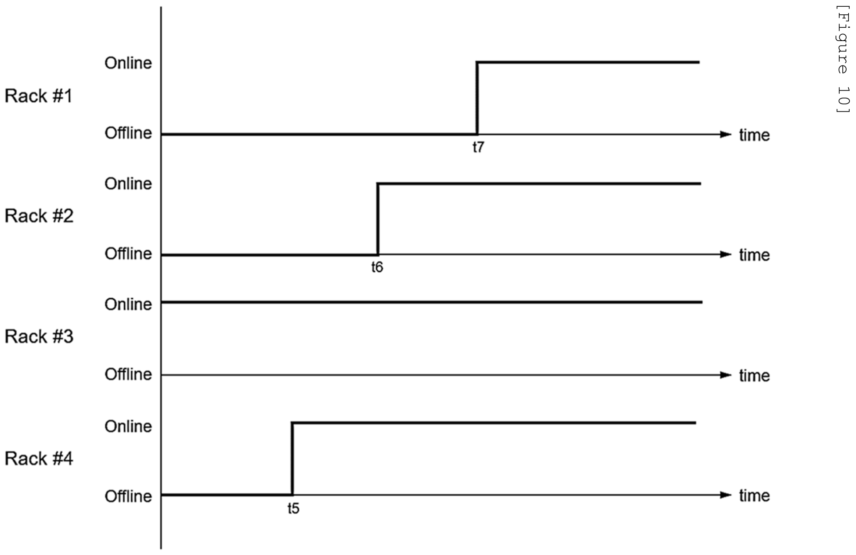

FIG. 10 is a reference diagram for explaining a battery control method according to another embodiment of the present invention.

Hereinafter, referring to FIG. 10, a battery control method according to another embodiment of the present invention will be explained using a battery system including four battery racks connected in parallel as an example.

The battery control apparatus may monitor the voltage of each of the racks (Rack #1 to #4) while the racks are being charged in an online state.

The battery control apparatus may correct the SOC of an online rack that has reached the target voltage until only one online battery remains, and may switch the rack for which SOC correction is completed to an offline state. For example, as illustrated in FIG. 10, the remaining racks (Rack #1, #2, #4) except Rack #3 may be sequentially switched to an offline state.

Afterwards, at time t5, if the voltage of Rack #3 reaches the target voltage, the battery control apparatus may compensate the SOC of Rack #3 while Rack #3 is being connected to the DC link and select a target rack whose voltage difference with Rack #3 is within a set voltage range (for example, 0.2 V). If Rack #4 is selected as the target rack, Rack #4 may be reconnected to the DC link at time t5 and switched to an online state, as shown in Fig. 10.

Thereafter, the battery control apparatus may select additional target racks while the online racks (Rack #3, #4) are being discharged and sequentially switch the selected target racks to an online state. For example, at time t6, if the voltage difference between the online racks (Rack #3, #4) and Rack #2 enters within the set range, the battery control apparatus may switch Rack #2 to an online state. Additionally, at time t7, if the voltage difference between the online racks (Rack #2, #3, #4) and Rack #1 falls within the set range, the battery control apparatus may bring Rack #1 online.

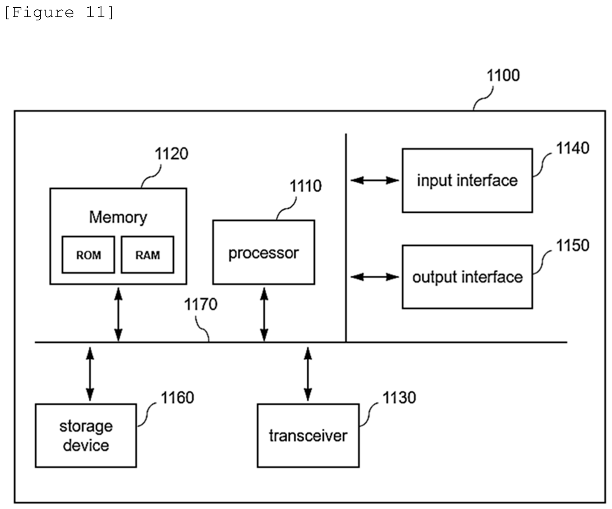

FIG. 11 is a block diagram of a battery control apparatus according to embodiments of the present invention.

The battery control apparatus 1100 according to embodiments of the present invention may be located in a battery system and linked with a battery management apparatus of each battery. For example, the battery control apparatus 1100 may correspond to a Battery System Controller (BSC), an Energy Management System (EMS), or a Power Management System (PMS), or may be implemented by being included in any one of them.

The battery control apparatus 1100 may include at least one processor 1110, a memory 1120 that stores at least one instruction executed by the processor, and a transceiver 1130 that is connected to a network and performs communication.

Here, the at least one instruction may include an instruction to monitor a voltage of each of the batteries while the batteries are connected in parallel to a direct current (DC) link and being charged; an instruction to sequentially disconnect at least one battery that has reached a predefined target voltage from the DC link; and an instruction to, upon the last battery connected to the DC link reaching the target voltage, reconnect one or more batteries, among the at least one battery disconnected from the DC link, of which voltage difference from the last battery is within a set range, to the DC link.

The instruction to sequentially disconnect the at least one battery that have reached the predefined target voltage from the DC link may include an instruction to transmit a switch control signal for causing a switch connecting a battery and the DC link to be switched to an open state to a battery management apparatus of the at least one battery that has reached the predefined target voltage.

The instruction to sequentially disconnect the at least one battery that have reached the predefined target voltage from the DC link may include an instruction to correct State Of Charge (SOC) of the at least one battery that has reached the predefined target voltage and disconnect the at least one battery from the DC link.

The instruction to sequentially disconnect the at least one battery that have reached the predefined target voltage from the DC link may include an instruction to, upon the last battery connected to the DC link reaching the target voltage, correct the SOC of the last battery while the last battery is being connected to the DC link.

The instruction to reconnect one or more batteries to the DC link may include an instruction to reconnect at least one battery, among the at least one battery disconnected from the DC link, of which the voltage difference from the last battery is within the set range and SOC correction is completed, to the DC link.

The instruction to reconnect one or more batteries to the DC link may include an instruction to, during a process of discharging at least one battery connected to the DC link, sequentially reconnect one or more batteries whose voltage difference from the at least one battery connected to the DC link falls within a set range, among at least one battery which is not reconnected to the DC link, to the DC link.

The instruction to sequentially disconnect at least one battery that has reached the predefined target voltage from the DC link may include an instruction to calculate an SOC of the battery system based on SOC of at least one battery connected to the DC link; and an instruction to adjust charge current of the at least one battery connected to the DC link to be attenuated by a predefined amount if the SOC of the battery system is equal to or greater than a determined SOC.

The battery control apparatus 1100 according to embodiments of the present invention may further include an input interface device 1140, an output interface device 1150, a storage device 1160, etc. Respective components included in the battery control apparatus 1100 may be connected by a bus 1170 and can communicate with each other.

Here, the processor 1110 may mean a central processing unit (CPU), a graphics processing unit (GPU), or a dedicated processor on which methods according to embodiments of the present invention are performed. The memory (or storage unit) may include at least one of a volatile storage medium and a non-volatile storage medium. For example, the memory may include at least one of read only memory (ROM) and random access memory (RAM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

**Claims**

1. A battery control apparatus located in a battery system including a plurality of batteries, the apparatus comprising:

   at least one processor; and
   a memory configured to store at least one instruction executed by the at least one processor,
   wherein the at least one instruction includes:

   an instruction to monitor a voltage of each of the batteries while the batteries are connected in parallel to a direct current (DC) link and being charged;
   an instruction to sequentially disconnect at least one battery that has reached a predefined target voltage from the DC link; and
   an instruction to, upon the last battery connected to the DC link reaching the target voltage, reconnect one or more batteries, among the at least one battery disconnected from the DC link, of which voltage difference from the last battery is within a set range, to the DC link.

2. The apparatus of claim 1, wherein the instruction to sequentially disconnect the at least one battery that have reached the predefined target voltage from the DC link includes:
an instruction to transmit a switch control signal for causing a switch connecting a battery and the DC link to be switched to an open state to a battery management apparatus of the at least one battery that has reached the predefined target voltage.

3. The apparatus of claim 1, wherein the instruction to sequentially disconnect the at least one battery that have reached the predefined target voltage from the DC link includes:
an instruction to correct State Of Charge (SOC) of the at least one battery that has reached the predefined target voltage and disconnect the at least one battery from the DC link.

4. The apparatus of claim 1, wherein the instruction to sequentially disconnect the at least one battery that have reached the predefined target voltage from the DC link includes:
an instruction to, upon the last battery connected to the DC link reaching the target voltage, correct the SOC of the last battery while the last battery is being connected to the DC link.

5. The apparatus of claim 4, wherein the instruction to reconnect one or more batteries to the DC link includes:
an instruction to reconnect at least one battery, among the at least one battery disconnected from the DC link, of which the voltage difference from the last battery is within the set range and SOC correction is completed, to the DC link.

6. The apparatus of claim 1, wherein the instruction to reconnect one or more batteries to the DC link includes:
an instruction to, during a process of discharging at least one battery connected to the DC link, sequentially reconnect one or more batteries whose voltage difference from the at least one battery connected to the DC link falls within a set range, among at least one battery which is not reconnected to the DC link, to the DC link.

7. The apparatus of claim 1, wherein the instruction to sequentially disconnect at least one battery that has reached the predefined target voltage from the DC link includes:

an instruction to calculate an SOC of the battery system based on SOC of at least one battery connected to the DC link; and
an instruction to adjust charge current of the at least one battery connected to the DC link to be attenuated by a predefined amount if the SOC of the battery system is equal to or greater than a determined SOC.

8. A battery control method performed by battery control apparatus located in a battery system including a plurality of batteries, the method comprising:

monitoring a voltage of each of the batteries while the batteries are connected in parallel to a direct current (DC) link and being charged;
sequentially disconnecting at least one battery that has reached a predefined target voltage from the DC link; and
upon the last battery connected to the DC link reaching the target voltage, reconnecting one or more batteries, among the at least one battery disconnected from the DC link, of which voltage difference from the last battery is within a set range, to the DC link.

9. The method of claim 8, wherein the sequentially disconnecting at least one battery that has reached a predefined target voltage from the DC link includes:
transmitting a switch control signal for causing a switch connecting a battery and the DC link to be switched to an open state to a battery management apparatus of the at least one battery that has reached the predefined target voltage.

10. The method of claim 8, wherein the sequentially disconnecting at least one battery that has reached a predefined target voltage from the DC link includes:
correcting a state of charge (SOC) of the at least one battery that has reached the predefined target voltage and disconnect the at least one battery from the DC link.

11. The method of claim 8, wherein the sequentially disconnecting at least one battery that has reached a predefined target voltage from the DC link includes:
upon the last battery connected to the DC link reaching the target voltage, correcting the SOC of the last battery while the last battery is being connected to the DC link.

12. The method of claim 11, wherein the reconnecting one or more batteries to the DC link includes:

reconnecting at least one battery, among the at least one battery disconnected from the DC link, of which the voltage difference from the last battery is within the set range and SOC correction is completed, to the DC link.

13. The method of claim 8, wherein the reconnecting one or more batteries to the DC link includes:
during a process of discharging at least one battery connected to the DC link, sequentially reconnecting one or more batteries whose voltage difference from the at least one battery connected to the DC link falls within a set range, among at least one battery which is not reconnected to the DC link, to the DC link.

14. The method of claim 8, wherein the sequentially disconnecting at least one battery that has reached a predefined target voltage from the DC link includes:

calculating an SOC of the battery system based on SOC of at least one battery connected to the DC link; and adjusting charge current of the at least one battery connected to the DC link to be attenuated by a predefined amount if the SOC of the battery system is equal to or greater than a determined SOC.

[Figure 1]

[Figure 2]

[Figure 3]

[Figure 4]

EP 4 726 959 A1

[Figure 5]

[Figure 6]

[Figure 7]

[Figure 8]

EP 4 726 959 A1

[Figure 9]

[Figure 10]

[Figure 11]

## INTERNATIONAL SEARCH REPORT

| International application No. |
|---|
| **PCT/KR2025/002090** |

| A. | CLASSIFICATION OF SUBJECT MATTER |
|---|---|

**H02J 7/00**(2006.01)i; **G01R 19/165**(2006.01)i; **G01R 31/382**(2019.01)i

According to International Patent Classification (IPC) or to both national classification and IPC

| B. | FIELDS SEARCHED |
|---|---|

Minimum documentation searched (classification system followed by classification symbols)

H02J 7/00(2006.01); B60L 58/19(2019.01); B60L 58/22(2019.01); H01M 10/42(2006.01); H01M 10/44(2006.01); H01M 10/48(2006.01); H02J 3/28(2006.01); H02J 3/36(2006.01); H02J 7/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 충전(charging), 병렬(parallel), 전압(voltage), 차이(difference), 순차(sequential), 탈락(elimination), 재연결(reconnection)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2014-0003201 A (SAMSUNG SDI CO., LTD.) 09 January 2014 (2014-01-09)<br>See paragraph [0049]; and claims 1 and 6. | 1-14 |
| DY | KR 10-2361334 B1 (LG CHEM, LTD.) 09 February 2022 (2022-02-09)<br>See paragraphs [0047] and [0055]-[0060]; claim 1; and figure 4. | 1-14 |
| A | KR 10-2024-0043639 A (LG ENERGY SOLUTION, LTD.) 03 April 2024 (2024-04-03)<br>See paragraphs [0013]-[0019]; and claim 1. | 1-14 |
| A | KR 10-2024-0057330 A (HUNATE CO., LTD.) 02 May 2024 (2024-05-02)<br>See claims 1-5. | 1-14 |
| A | KR 10-2015-0081731 A (SAMSUNG SDI CO., LTD.) 15 July 2015 (2015-07-15)<br>See paragraphs [0006], [0026] and [0054]; and claims 1-6. | 1-14 |

| ✓ | Further documents are listed in the continuation of Box C. | | ✓ | See patent family annex. |
|---|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **23 May 2025** | **25 May 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| International application No. |
| --- |
| **PCT/KR2025/002090** |

### C.    DOCUMENTS CONSIDERED TO BE RELEVANT

| Category* | Citation of document, with indication, where appropriate, of the relevant passages | Relevant to claim No. |
| --- | --- | --- |
| A | KR 10-2021-0133029 A (ENERTECH INTERNATIONAL, INC.) 05 November 2021 (2021-11-05)<br>See claims 1, 5 and 6. | 1-14 |

Form PCT/ISA/210 (second sheet) (July 2022)

## INTERNATIONAL SEARCH REPORT
### Information on patent family members

International application No.

**PCT/KR2025/002090**

| Patent document cited in search report | | | Publication date (day/month/year) | Patent family member(s) | | | Publication date (day/month/year) |
|---|---|---|---|---|---|---|---|
| KR | 10-2014-0003201 | A | 09 January 2014 | KR | 10-1648239 | B1 | 12 August 2016 |
| | | | | US | 2014-0002003 | A1 | 02 January 2014 |
| | | | | US | 9219366 | B2 | 22 December 2015 |
| KR | 10-2361334 | B1 | 09 February 2022 | AU | 2019-265165 | A1 | 28 May 2020 |
| | | | | AU | 2019-265165 | B2 | 08 February 2024 |
| | | | | CN | 111133655 | A | 08 May 2020 |
| | | | | CN | 111133655 | B | 14 November 2023 |
| | | | | EP | 3687027 | A1 | 29 July 2020 |
| | | | | EP | 3687027 | A4 | 11 November 2020 |
| | | | | EP | 3687027 | B1 | 21 August 2024 |
| | | | | ES | 2992136 | T3 | 09 December 2024 |
| | | | | HU | E068723 | T2 | 28 January 2025 |
| | | | | JP | 2020-532268 | A | 05 November 2020 |
| | | | | JP | 7045570 | B2 | 01 April 2022 |
| | | | | KR | 10-2019-0128913 | A | 19 November 2019 |
| | | | | PL | 3687027 | T3 | 18 November 2024 |
| | | | | US | 11381094 | B2 | 05 July 2022 |
| | | | | US | 2020-0244075 | A1 | 30 July 2020 |
| | | | | WO | 2019-216532 | A1 | 14 November 2019 |
| KR | 10-2024-0043639 | A | 03 April 2024 | CN | 118414763 | A | 30 July 2024 |
| | | | | EP | 4432512 | A1 | 18 September 2024 |
| | | | | JP | 2025-501315 | A | 17 January 2025 |
| | | | | KR | 10-2658099 | B1 | 17 April 2024 |
| | | | | US | 2024-0332997 | A1 | 03 October 2024 |
| | | | | WO | 2024-071593 | A1 | 04 April 2024 |
| KR | 10-2024-0057330 | A | 02 May 2024 | None | | | |
| KR | 10-2015-0081731 | A | 15 July 2015 | US | 2015-0194707 | A1 | 09 July 2015 |
| KR | 10-2021-0133029 | A | 05 November 2021 | KR | 10-2365552 | B1 | 21 February 2022 |
| | | | | WO | 2021-221219 | A1 | 04 November 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240061166

- KR 102361334